# EUROPEAN PATENT APPLICATION

(11) **EP 2 756 996 A1**
(43) Date of publication of application: **23.07.2014**
(21) Application number: 13193292.3
(22) Date of filing: 18.11.2013
(51) Int. Cl.: B60R 16/023, H05K 1/14, H02G 3/08

(54) **Electrical junction box**

(30) Priority: 17.01.2013 JP 2013006761
(71) Applicant: Sumitomo Wiring Systems, Ltd., Yokkaichi Mie 510-8503 (JP)
(72) Inventor: Shi, Wenjie, Yokkaichi, Mie 510-8503 (JP)
(74) Representative: Horn Kleimann Waitzhofer

(57) **Abstract**

Provided is an electrical junction box in which a printed circuit board is accommodated in a case so as to configure an internal circuit, the electrical junction box having a new structure that can achieve downsizing/densification of the electrical junction box by configuring the internal circuit with a high space efficiency and simplifying routing of electric cables of connectors. As the internal circuit, a printed circuit board stack (16) is used in which a first printed circuit board (18) and a second printed circuit board (20) are arranged so as to face each other. A power supply input connector (70) that is to be mounted to a front wall-side connector mounting portion (53) provided on a front wall (47) of a case (15) is connectable to the first printed circuit board (18), whereas an output connector (80) that is to be mounted to a rear wall-side connector mounting portion (55) provided on a rear wall (48) of the case (15) is connectable to the second printed circuit board (20).

## Description

### TECHNICAL FIELD

The present invention relates to an electrical junction box in which a printed circuit board is accommodated in a case so as to constitute an internal circuit.

### BACKGROUND ART

Conventionally, as an electrical junction box that is installed in an automobile, an electrical junction box is known in which a printed circuit board is accommodated inside so as to constitute an internal circuit. In such an electrical junction box, as disclosed in, for example, JP 2008-295221 A (Patent Document 1), a power supply input connector that is arranged upstream and configured to supply power and signals, and output connectors configured to output, to various types of loads, power supply and signals branched via printed wirings are connected to the printed circuit board, thereby achieving efficient branching/distribution of power supply and the like.

Meanwhile, in recent years, due to an increase in the number of in-vehicle electrical components, the number of branch circuits on the printed circuit board and the number of connectors connected to the printed circuit board are increasing. Accordingly, various types of measures have been proposed in order to constitute the internal circuit with high space efficiency and obtain the internal circuit with high density without making the dimensions of the electrical junction box larger. Specifically, it has been proposed, as disclosed in Patent Document 1, to arrange through-holes of terminals to which connectors are connected closer to regions in which the electrical components are installed, thereby improving the efficiency in routing printed wiring patterns.

However, densification of the internal circuit is not sufficiently achieved only by such measures for efficiently routing printed wiring patterns, and there are some cases where the printed circuit board has to be made larger in order for a branch circuit and a connector mounting portion to additionally be configured thereon. Also, since regions of the printed circuit board on which the connectors are mounted are concentrated on one side of the printed circuit board, at least one electric cable of the power supply input connector or the output-side connectors that extends from the other side of the printed circuit board needs to be routed onto and connected to the one side of the printed circuit board while making a U-turn like curve. Therefore, the routing operation of the electric cable is complicated, and the electric cable, due to its rigidity, inevitably significantly protrudes to the outer peripheral side of the electrical junction box, thus causing a problem that a large space in which the electrical junction box is installed needs to be ensured.

JP 2008-295221A (Patent Document 1) is an example of related art.

The present invention is made in view of the above-described circumstances, and the problem to be solved is to provide an electrical junction box in which a printed circuit board is accommodated in a case so as to constitute an internal circuit, the electrical junction box having a new structure that can efficiently achieve downsizing/densification of the electrical junction box by configuring the internal circuit with an excellent space efficiency and simplifying routing of electric cables of connectors.

### SUMMARY OF THE INVENTION

A first aspect of the present invention is an electrical junction box, wherein a first and a second printed circuit board are accommodated in a case so as to configure an internal circuit, the internal circuit comprises a printed circuit board stack in which respective printed wirings of the first printed circuit board and the second printed circuit board are electrically connected to each other via an inter-board connection terminal (which may also be referred to as "inter-board connection structure"), the first printed circuit board and the second printed circuit board being arranged so as to face each other across a gap, the case has a front wall and a rear wall that are arranged so as to face the printed circuit board stack from both sides in a direction in which the first printed circuit board and the second printed circuit board face each other, a front wall-side connector mounting portion for mounting a power supply input connector is provided on the front wall of the case in such a manner that the power supply input connector is connectable to the first printed circuit board, and a rear wall-side connector mounting portion for mounting an output connector is provided on the rear wall of the case in such a manner that the output connector is connectable to the second printed circuit board. The first printed circuit board and the second printed circuit board may extend parallel to each other, with a gap between them, in which case the "direction in which the first printed circuit board and the second printed circuit board face each other" is the direction orthogonal to the planes of the first and second printed circuit board.

In the electrical junction box that has the structure according to the present invention, the internal circuit may be configured by arranging, on the first printed circuit board, an electrical circuit to which the power supply input connector from the battery side is to be connected and arranging, on the second printed circuit board, an electrical circuit to which the output connector to the load side is to be connected, while separating the first printed circuit board the second printed circuit board from each other, and stacking them. With this, it is possible to downsize the printed circuit boards, as compared with a situation where a connector mounting portion for a power supply input connector and a connector mounting portion for an output connector are arranged in parallel to each other on a single printed circuit board. As a result, it is possible to form the internal circuit while efficiently using the space within the case, and to achieve downsizing/densification of the electrical junction box.

Also, the first printed circuit board is arranged on the front wall side of the case and the second printed circuit board is arranged on the rear wall side of the case, and the power supply input connector is to be mounted on the front wall side of the case and the output connector is to be mounted on the rear wall side of the case. With this, only by arranging, when the electrical junction box is installed in an automobile, the front wall of the case on a battery side, that is, an engine room side for example and arranging the rear wall of the case on a load side, that is, a vehicle interior side for example, it is possible to eliminate the need of routing electric cables of the power supply input connector and the output connector in U-turn like curves, thus allowing simple routing of the electric cables to be connected to the electrical junction box and the routing of the electric cables with minimum required lengths. In particular, by applying the present invention to an electrical junction box that is arranged on an instrument panel of a vehicle, it is possible to perform a mounting operation for mounting connectors and fuses from the engine room side and from the vehicle interior side very easily, leading to simple routing of the electric cables. As a result, it is also possible to downsize a space in which the electrical junction box is installed.

A second aspect of the present invention is the electrical junction box of the first aspect, wherein a first fork terminal that is soldered to the printed wiring of the first printed circuit board is vertically arranged on the first printed circuit board whereas a second fork terminal that is soldered to the printed wiring of the second printed circuit board is vertically arranged on the second printed circuit board, and the inter-board connection terminal comprises the first fork terminal, the second fork terminal, and a fuse that is provided with a pair of connection portions, each connection portion being pressure-contacted between pressure contact blades of a respective one of the first fork terminal and the second fork terminal.

According to this aspect, by connecting the fuse while being arranged on both the fork terminals that are respectively soldered to and vertically provided on the first printed circuit board and the second printed circuit board, a conductive connection between the first printed circuit board and the second printed circuit board can be realized. With this, it is possible to omit an inter-board connection terminal whose two ends are soldered to two printed circuit boards as in a conventional structure, and also to omit a complicated operation in which one end of the inter-board connection terminal is soldered to one printed circuit board, then the other end is inserted into a through-hole of the other printed circuit board and soldered thereto, and the like. As a result, operability of an operation for connecting the first printed circuit board and the second printed circuit board can be improved. Further, it is possible to prevent the problem of the conventional inter-board connection terminal, that is, the occurrence of solder cracking that is caused due to the displacement between the two printed circuit boards to which the two ends of the inter-board connection terminal are soldered, and also to improve the stability of connection between the printed circuit boards.

In addition, since the fork terminals that are each provided with pressure contact blades are vertically provided on the first printed circuit board and the second printed circuit board, and the connections of the fuse are connected to the fork terminals while being pressure-contacted between the corresponding pressure contact blades, the operation for connecting the fuse to the first fork terminal and to the second fork terminal can easily be performed. Furthermore, by using the pressure contact force of the pressure contact blades, it is possible to maintain a stable electrical conduction between the fuse and the fork terminals, allowing an improvement in stability of connection between the first printed circuit board and the second printed circuit board.

Also, the first fork terminal of the first printed circuit board and the second fork terminal of the second printed circuit board are connected to each other via the fuse. In an internal circuit of an electrical junction box, a fuse is generally interposed in a stage where a circuit to which the power supply input connector is connected is branched to a circuit connected to the output connector, and the fuse is connected to printed circuit boards via fork terminals. Therefore, by such a fuse, which is an essential member, as well as the fork terminals connecting the first printed circuit board and the second printed circuit board, and functioning as an inter-board connection terminal, it is possible to omit an inter-board connection terminal that is used only for connecting the both printed circuit boards. This allows further downsizing of the printed circuit board stack that constitutes an internal circuit, and more efficient use of spaces on the first printed circuit board and the second printed circuit board.

A third aspect of the present invention is the electrical junction box of the second aspect, wherein the first fork terminal and the second fork terminal have different heights that are set such that the pressure contact blades of the first fork terminal and the pressure contact blades of the second fork terminal are arranged at the same level in a direction in which the fuse is connected.

According to this aspect, the pressure contact blades of the first fork terminal and the pressure contact blades of the second fork terminal are arranged at the same level in a direction in which the fuse is connected. Therefore, a general-purpose fuse that is provided with a pair of connection portions can advantageously be used, the connections being located at the same level in a direction of being connected to the fork terminals.

A fourth aspect of the present invention is the electrical junction box of the second or third aspect, wherein the second fork terminal is vertically provided at a peripheral edge portion of the second printed circuit board, whereas the first fork terminal is vertically provided at a peripheral edge portion of the first printed circuit board, the peripheral edge portion of the first printed circuit board that is separated from the second printed circuit board across a gap is located inward of the peripheral edge portion of the second printed circuit board, the second fork terminal projects towards and beyond a plane in which the first printed circuit board is arranged, and the pressure contact blades of the first fork terminal and the pressure contact blades of the second fork terminal are arranged so as to face each other in a direction in which the first and second printed circuit board extend.

According to this aspect, the peripheral edge portion of the first printed circuit board is separated from the peripheral edge portion of the second printed circuit board in the horizontal direction, and the first fork terminal and the second fork terminal are vertically provided at the peripheral edge portions of the respective printed circuit boards. Accordingly, it is possible to arrange the first fork terminal and the second fork terminal, together with the fuse, that are used for connecting the first printed circuit board and the second printed circuit board, at the peripheral edge portions of the respective first printed circuit board and the second printed circuit board. This makes it possible to ensure spaces in the central portions of the first printed circuit board and the second printed circuit board and to achieve an efficient use of the printed circuit boards. Also, since the second fork terminal of the second printed circuit board projects upward beyond the first printed circuit board by locating the peripheral edge portion of the first printed circuit board inward of the peripheral edge portion of the second printed circuit board, the first printed circuit board does not need to have a through-hole or a cut-out through which the second fork terminal is inserted. Accordingly, it is possible to easily manufacture the first printed circuit board in a simple shape, and to perform connection between the boards while efficiently maintaining the rigidity of the first printed circuit board.

In the present invention, as an internal circuit, a printed circuit board stack in which a first printed circuit board and a second printed circuit board are disposed so as to face each other and connected to each other is used, and a power supply input connector mounted on the front wall side of a case is configured to be connectable to the first printed circuit board, whereas an output connector mounted on the rear wall side of the case is configured to be connectable to the second printed circuit board. It is thus possible to downsize the internal circuit and improve space efficiency of the case as compared with a situation where the power supply input connector and the output connectors are connected in parallel to one another on one side of the printed circuit board, allowing downsizing and densification of the electrical junction box to be achieved. Further, by mounting the power supply input connector and the output connectors respectively on the facing sides of the case, it is possible to eliminate the need of routing an electric cable of the connector around the electrical junction box while making a U-shaped curve, and to achieve downsizing of a space in which the electrical junction box is installed.

### BRIEF DESCRIPTION OF THE DRAWINGS

Fig. 1 is a cross-sectional view illustrating an electrical junction box according to a first embodiment of the present invention.
Fig. 2 is a top view illustrating a printed circuit board stack that is to be provided in the electrical junction box shown in Fig. 1.
Fig. 3 is an enlarged view illustrating a main portion that is seen in a direction A of Fig. 2.
Fig. 4 is an enlarged view illustrating the main portion that is seen in a direction B of Fig. 2.
Fig. 5 is a diagram illustrating a state in which the electrical junction box shown in Fig. 1 is installed in a vehicle.
Fig. 6 is a top view illustrating a main portion of a printed circuit board stack that is to be provided in an electrical junction box according to a second embodiment of the present invention.
Fig. 7 is a top view illustrating a main portion of a printed circuit board stack that is to be provided in an electrical junction box according to a third embodiment of the present invention.

### EMBODIMENTS OF THE INVENTION

Hereinafter, embodiments of the present invention will be described with reference to the accompanied drawings.

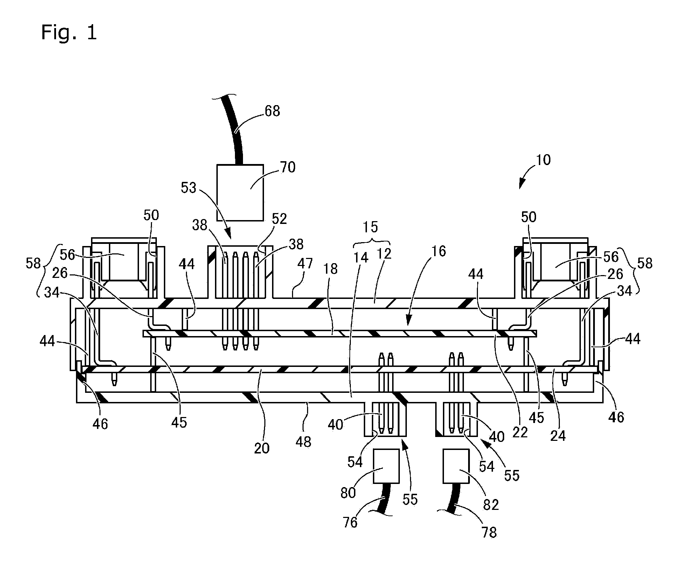

First, Fig. 1 shows an electrical junction box 10 according to a first embodiment of the present invention. The electrical junction box 10 has a configuration in which a printed circuit board stack 16 that serves as an internal circuit is accommodated in a case 15 that is constituted by an upper case 12 and a lower case 14 that are made from a synthetic resin. Note that in the following description, "upper" refers to the upper side of Fig. 1, that is, on the side of the upper case 12, whereas "lower" refers to the lower side of Fig. 1, that is, on the side of the lower case 14.

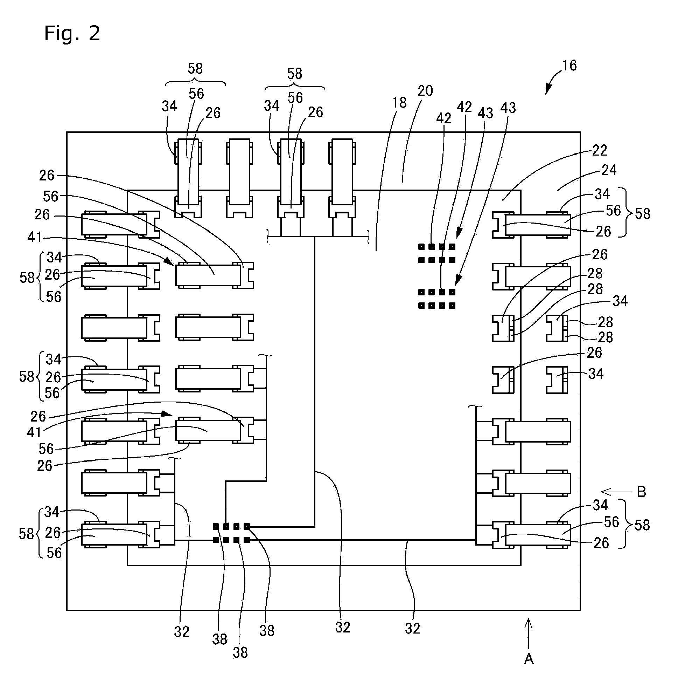

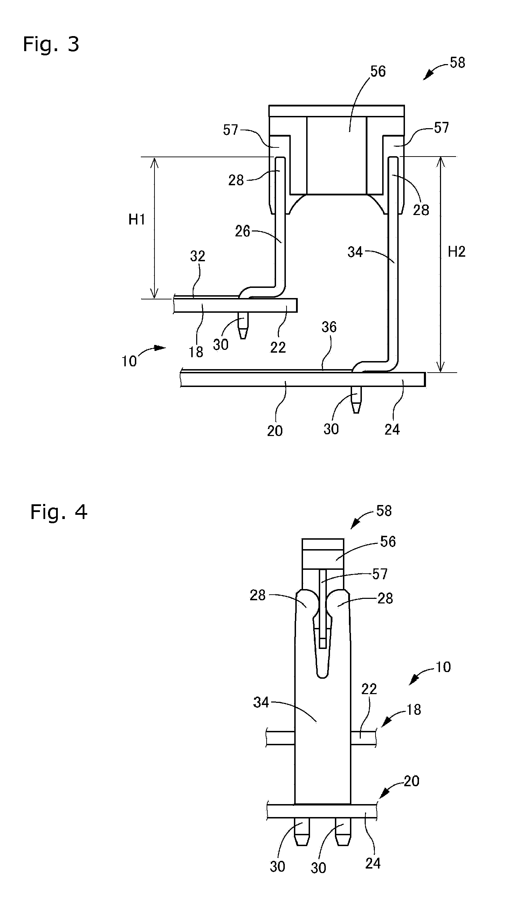

Fig. 2 shows a top view of the printed circuit board stack 16, and Figs. 3 and 4 show a main portion of the printed circuit board stack 16. Note that Figs. 2 to 4 also show a fuse 56, which are described later, for the sake of easy understanding. The printed circuit board stack 16 has a structure in which a first printed circuit board 18 and a second printed circuit board 20 are stacked, the first printed circuit board 18 being disposed above the second printed circuit board 20 so as to face the second printed circuit board 20 across a gap. The first printed circuit board 18 and the second printed circuit board 20 are each configured to be in the shape of a substantially rectangular plate. The first printed circuit board 18 is configured to have a size that is smaller than that of the second printed circuit board 20 when seen in the top view (see Fig. 2). Accordingly, a peripheral edge portion 22 of the first printed circuit board 18 is located, when seen in the top view, inward of a peripheral edge portion 24 of the second printed circuit board 20 and, in the present embodiment, the peripheral edge portion 24 of the second printed circuit board 20 projects outward from the entire perimeter of the peripheral edge portion 22 of the first printed circuit board 18.

A plurality of first fork terminals 26 are vertically provided at the peripheral edge portion 22 of the first printed circuit board 18. Each first fork terminal 26 is made in one piece from a metal sheet, and one end thereof is substantially U-shaped, like a fork such that a pair of pressure contact blades 28 is formed so as to face each other across a gap. The other end of the first fork terminal 26 that is opposite to the pressure contact blades 28 is provided with a pair of soldered portions 30. Note that the soldered portions 30 of the present embodiment are bent in the shape of cranks and configured to be able to support the first fork terminal 26 against the push-in force of the fuse 56 by abutting on the first printed circuit board 18 at the time of connection of the fuse 56, which will be described later. However, the soldered portions 30 may also be in the shape extending straight in the longitudinal direction of the first fork terminal 26 (vertical direction of Fig. 3). By such soldered portions 30 of the first fork terminal 26 being inserted into through-holes (not shown) provided at the peripheral edge portion 22 of the first printed circuit board 18 and soldered to a printed wiring 32 that is formed on the first printed circuit board 18, the plurality of first fork terminals 26 are vertically provided with an appropriate distance at the peripheral edge portion 22 in the circumferential direction of the peripheral edge portion 22. Note that, in the present embodiment, the plurality of first fork terminals 26 are arranged over three sides of the peripheral edge portion 22 of the first printed circuit board 18.

On the other hand, a plurality of second fork terminals 34 are vertically provided at the peripheral edge portion 24 of the second printed circuit board 20. In the drawings, the same reference numerals as those of the first fork terminals 26 are given to portions of the second fork terminals 34 that have the same structure as those of the first fork terminals 26, and descriptions thereof are omitted. That is, the second fork terminals 34 each differ from the first fork terminals 26 in the size of length (size in the vertical direction in Fig. 3), and have a length that is longer than that of the first fork terminals 26. Similarly to the case of the first fork terminals 26, such second fork terminals 34 are vertically provided at the peripheral edge portion 24 of the second printed circuit board 20 by the soldered portions 30 of the second fork terminals 34 being soldered to a printed wiring 36 of the second printed circuit board 20.

Also, as shown in Fig. 1, a plurality of input connector connection terminals 38, serving as metallic terminals, are soldered to the first printed circuit board 18 and provided so as to project to the side opposite to the second printed circuit board 20. On the other hand, a plurality of output connector connection terminals 40, serving as metallic terminals, are soldered to the second printed circuit board 20 and provided so as to project to the side opposite to the first printed circuit board 18. Metallic terminals in various types of shapes may appropriately be applied to these input connector connection terminals 38 and the output connector connection terminals 40, depending on a power supply input connector 70 or output connectors 80 and 82, which are described later. For example, metallic terminals of any shape, such as the shape of a pin having a square cross-section or a circular cross-section, or a tab having a rectangular cross-section can be employed. The input connector connection terminals 38 are soldered to the printed wiring 32 (see Fig. 3) on the first printed circuit board 18 and electrically connected to at least one of the plurality of first fork terminals 26, whereas the output connector connection terminals 40 are soldered to the printed wiring 36 on the second printed circuit board 20 and electrically connected to at least one of the plurality of second fork terminals 34.

Note that, as is clear from Fig. 2, the central portion of the first printed circuit board 18 is provided with fuse connectors 41 that are each formed by a pair of first fork terminals 26 arranged so as to face each other, or connector mounting portions 43 that are each formed by the arbitrary number of connection terminals 42 provided so as to project, as with in a conventional technology. Note that, although Fig. 2 shows the connection terminals 42 that have the same shape as that of the input connector connection terminals 38, the connection terminals 42 may have any shape depending on the connector (not shown) to be connected thereto.

The first printed circuit board 18 and the second printed circuit board 20 of the present embodiment are respectively supported by the upper case 12 and the lower case 14, and thereby are positioned facing each other across a gap. As shown in Fig. 1, for example, the first printed circuit board 18 is supported between support bosses 44 that project from the upper case 12 and support bosses 45, which project from the lower case 14 and are inserted into through-holes (not shown) provided on the second printed circuit board 20. On the other hand, the second printed circuit board 20 is supported between support bosses 44 that project from the upper case 12 and a support wall 46, which is formed at an inner surface of the peripheral wall of the lower case 14. However, the present invention is no way limited to the specific configuration in which the first printed circuit board 18 and the second printed circuit board 20 are positioned in a stacked state, and a configuration is also applicable in which, for example, an insulating plate made from a synthetic resin is disposed between the first printed circuit board 18 and the second printed circuit board 20, and both the first printed circuit board 18 and the second printed circuit board 20 are fixed to the insulating plate.

By positioning the first printed circuit board 18 and the second printed circuit board 20 with respect to each other in the stacked state, the peripheral edge portion 22 of the first printed circuit board 18 is positioned inward of the peripheral edge portion 24 of the second printed circuit board 20. Since, as described above, the second fork terminal 34 is configured to have a length that is longer than that of the first fork terminal 26, as shown in Fig. 3, the height H2 of the second fork terminal 34 from the second printed circuit board 20 is greater than the height H1 of the first fork terminal 26 from the first printed circuit board 18, and the second fork terminal 34 projects upward (to the upper side in Fig. 3) beyond the first printed circuit board 18. Accordingly, the pressure contact blades 28 of the first fork terminal 26 and the pressure contact blades 28 of the second fork terminal 34 are arranged so as to face each other in the horizontal direction (lateral direction in Fig. 3), and are arranged at the same level with respect to the vertical direction in which the first printed circuit board 18 and the second printed circuit board 20 face each other (vertical direction in Fig. 3), that is, in a direction in which the later-described fuse 56 is connected thereto.

The printed circuit board stack 16 that has such a structure is accommodated in the case 15 constituted by the upper case 12 and the lower case 14. Therefore, as shown in Fig. 1, a front wall 47 and a rear wall 48 of the case 15 are arranged so as to face the printed circuit board stack 16 from both sides in the direction in which the first printed circuit board 18 and the second printed circuit board 20 face each other (vertical direction of Fig. 1), and thus the first printed circuit board 18 is arranged on the side of the front wall 47, whereas the second printed circuit board 20 is arranged on the side of the rear wall 48.

Also, the first fork terminal 26 and the second fork terminal 34 that face each other are inserted into terminal insertion holes (not shown) provided on the upper case 12, and are arranged in each of a plurality of fuse accommodation cavities 50 provided on the upper case 12. Further, the input connector connection terminals 38 vertically provided on the first printed circuit board 18 are inserted into terminal insertion holes (not shown) provided in the upper case 12, and are arranged in an input connector accommodation cavity 52 provided in the upper case 12, thereby forming a front wall-side connector mounting portion 53 on the front wall 47. On the other hand, the output connector connection terminals 40 vertically provided on the second printed circuit board 20 are inserted into terminal insertion holes provided in the lower case 14, and are arranged in each of a plurality of output connector accommodation cavities 54 provided in the lower case 14, thereby forming a plurality of rear wall-side connector mounting portions 55 on the rear wall 48. Further, although illustration is omitted, the first fork terminals 26 that constitute the fuse connectors 41 (see Fig. 2) provided on the first printed circuit board 18, and the connection terminals 42 that constitute the connector mounting portions 43 are also connectable to a fuse or connector by passing through the upper case 12 and being accommodated in a fuse accommodation cavity or a connector accommodation cavity that is formed on the front wall 47.

Also, the fuses 56 are inserted into the fuse accommodation cavities 50. Each fuse 56 is a conventionally well-known fuse and provided with a pair of connection portions 57 in the shape of plates that are provided in a projecting manner and connected to each other via a portion to be fused (not shown). When such a fuse 56 is inserted into each fuse accommodation cavity 50, one of the connection portions 57 is pressure-contacted between the pressure contact blades 28 of the first fork terminal 26 and the other of the connection portions 57 is pressure-contacted between the pressure contact blades 28 of the second fork terminal 34, in each fuse accommodation cavity 50 (see Figs. 3 and 4). Accordingly, the fuse 56 is connected to the first fork terminal 26 and the second fork terminal 34, and the printed wiring 32 of the first printed circuit board 18 and the printed wiring 36 of the second printed circuit board 20 are electrically connected to each other via the first fork terminal 26, the second fork terminal 34, and the fuse 56. In this manner, according to the present embodiment, an inter-board connection terminal 58 via which the printed wiring 32 of the first printed circuit board 18 and the printed wiring 36 of the second printed circuit board 20 are electrically connected to each other, comprises the first fork terminal 26, the second fork terminal 34, and the fuse 56.

Note that the fuse 56, which is connected to the first fork terminal 26 and to the second fork terminal 34, is a fuse that is provided on, for example, a power feeding path that extends from a power supply of the automobile to a load and, according to the present embodiment, the fuse 56 is electrically connected to a load arranged on the vehicle interior side, such as an audio device, a meter, an AC power supply port, a navigation system, a blower motor, or an electronic control unit arranged in a cockpit module.

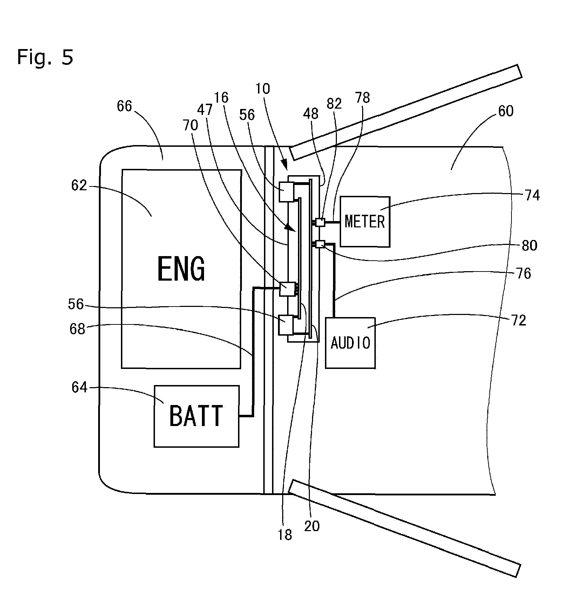

As shown in Fig. 5, for example, the electrical junction box 10 that has such a structure is arranged within a vehicle interior 60. In particular, the electrical junction box 10 according to the present embodiment may be arranged in a state in which the front wall 47 of the electrical junction box 10 on which the fuse accommodation cavities 50 and the front wall-side connector mounting portion 53 are provided faces an engine room 66 in which an engine 62, a battery 64, and the like are accommodated, and the rear wall 48 of the electrical junction box 10 on which the rear wall-side connector mounting portions 55 are provided faces the vehicle interior 60.

Also, by the power supply input connector 70 provided on the terminal of a wire harness 68, which serves as an electric cable and is electrically connected to a battery 64, being mounted in the front wall-side connector mounting portion 53 to connect to the input connector connection terminals 38, the power supply input connector 70 is electrically connected to the printed wiring 32 of the first printed circuit board 18. Also, by the output connectors 80 and 82 provided on the terminals of wire harnesses 76 and 78, which serve as electric cables and are connected to an audio device 72 and a meter 74 serving as loads, being mounted in the rear wall-side connector mounting portions 55 to connect to the connector connection terminals 40, the output connectors 80 and 82 are electrically connected to the printed wirings 36 of the second printed circuit board 20. As a result, the power supply input connector 70 is electrically connected to the output connectors 80 and 82 via the first printed circuit board 18, the first fork terminal 26, the fuse 56, the second fork terminal 34, and the second printed circuit board 20, and thus an electrically-conducting path that connects the power supply input connector 70 to the output connectors 80 and 82 is formed via the printed circuit board stack 16.

In the electrical junction box 10 that has such a structure, the internal circuit is formed using the printed circuit board stack 16 in which the first printed circuit board 18 and the second printed circuit board 20 are arranged in a stack, and the power supply input connector 70 extending from the battery 64 is connected to the first printed circuit board 18, whereas the output connectors 80 and 82 that are respectively coupled to the audio device 72 and the meter 74 serving as loads are connected to the second printed circuit board 20. Accordingly, it is possible to make the first printed circuit board 18 and the second printed circuit board 20 smaller as compared with the situation where the power supply input connector 70 and the output connectors 80 and 82 are mounted in parallel to one another on a single printed circuit board, allowing an effective use of a space within the case 15. As a result, it is possible to achieve downsizing/densification of the electrical junction box 10.

Further, the front wall-side connector mounting portion 53 in which the power supply input connector 70 is to be mounted is formed on the front wall 47 of the case 15, and the rear wall-side connector mounting portions 55 in which the output connectors 80 and 82 are to be mounted are formed on the rear wall 48 opposite to the front wall 47. Therefore, by arranging the front wall 47 on the engine room 66 side on which the battery 64 is provided, and arranging the rear wall 48 on the vehicle interior 60 side on which the audio device 72, the meter 74, and the like, which serve as loads, are provided, it is possible to connect the power supply input connector 70 and the output connectors 80 and 82 to the electrical junction box 10 without routing the wire harnesses 68, 76, and 78 around the electrical junction box 10. This leads to simple routing of the wire harnesses 68, 76, and 78, and thus it is possible to perform easy operations for mounting the connectors 70, 80, and 82, and the fuse 56 to the electrical junction box 10 from the engine room 66 side and the vehicle interior 60 side at the time of manufacturing of vehicles, and to route the wire harnesses 68, 76, and 78 with minimum required lengths and with high space efficiency.

Moreover, the printed circuit board stack 16 that constitutes the internal circuit has a configuration in which the inter-board connection terminals 58 that connect the first printed circuit board 18 and the second printed circuit board 20 include the first fork terminals 26, the second fork terminals 34, and the fuses 56 that are connected to both terminals 26 and 34. Therefore, unlike a conventional structure in which both printed circuit boards are connected to each other by a large number of inter-board connection terminals, it is possible to omit a complicated operation in which each one end of the large number of inter-board connection terminals is soldered to one printed circuit board, then each other end thereof is inserted into a through-hole of the other printed circuit board and soldered to the printed circuit board, and the like. This makes it possible to perform easy connection between the first printed circuit board 18 and the second printed circuit board 20. Further, by using the pressure contact force of the pressure contact blades 28 of the first fork terminal 26 and the pressure contact force of the pressure contact blades 28 of the second fork terminal 34, it is possible to stably connect both of the first fork terminal 26 and the second fork terminal 34 to the fuse 56, and to prevent the solder cracking that occurs due to the displacement of the printed circuit boards in the case where the conventional inter-board connection terminal is used, achieving an improvement in the reliability of connection between the first printed circuit board 18 and the second printed circuit board 20.

Also, since the inter-board connection terminals 58 are configured by effectively using the fuses 56, which are required to prevent an excess current from flowing to the audio device 72 and the meter 74, and the first fork terminals 26 and the second fork terminals 34, which are required for the fuses 56 to be connected to the printed circuit boards, it is not necessary to provide a specific inter-board connection terminal required only for connecting the printed circuit boards to each other, thus achieving a reduction in the number of components, and enabling the first printed circuit board 18 and the second printed circuit board 20 to be used more efficiently.

Furthermore, the first fork terminals 26 and the second fork terminals 34 are vertically provided at the respective peripheral edge portions 22 and 24 of the first printed circuit board 18 and the second printed circuit board 20. With this, effective spaces of the first printed circuit board 18 and the second printed circuit board 20 can be ensured more advantageously, achieving more efficient use of the first printed circuit board 18 and the second printed circuit board 20, and downsizing of the printed circuit board stack 16.

In addition, by positioning the peripheral edge portion 22 of the first printed circuit board 18 inward of the peripheral edge portion 24 of the second printed circuit board 20, it is possible to arrange the first fork terminal 26 and the second fork terminal 34 that are vertically provided at the respective peripheral edge portions 22 and 24 so as to face each other. In particular, since the first printed circuit board 18 does not need to have insertion holes and the like through which the second fork terminals 34 project upward, it is possible to ensure the strength of the first printed circuit board 18, and since the shapes of the first printed circuit board 18 and the second printed circuit board 20 are made simple, it is possible to achieve a reduction in the manufacturing cost. Also, since the fuses 56 that are each included in the inter-board connection terminal 58 can be arranged at the peripheral edge portion 22 of the first printed circuit board 18, efficient use of the central portion of the first printed circuit board 18 is possible and a space in which the fuse connectors 41 (see Fig. 2), the connector mounting portions 43, and the like are formed can advantageously be ensured.

Moreover, since the pressure contact blades 28 of the first fork terminals 26 and the pressure contact blades 28 of the second fork terminals 34 are located at the same level with respect to a direction in which the fuses 56 are inserted (direction from the upper side to the lower side in Fig. 3), general-purpose fuses that are conventionally widely used can be employed as the fuses 56, thus allowing a reduction in the manufacturing cost. In addition, since the connection portions 57 of the fuse 56 can simultaneously be connected to the first fork terminal 26 and to the second fork terminal 34, it is possible to perform the connection operation more smoothly.

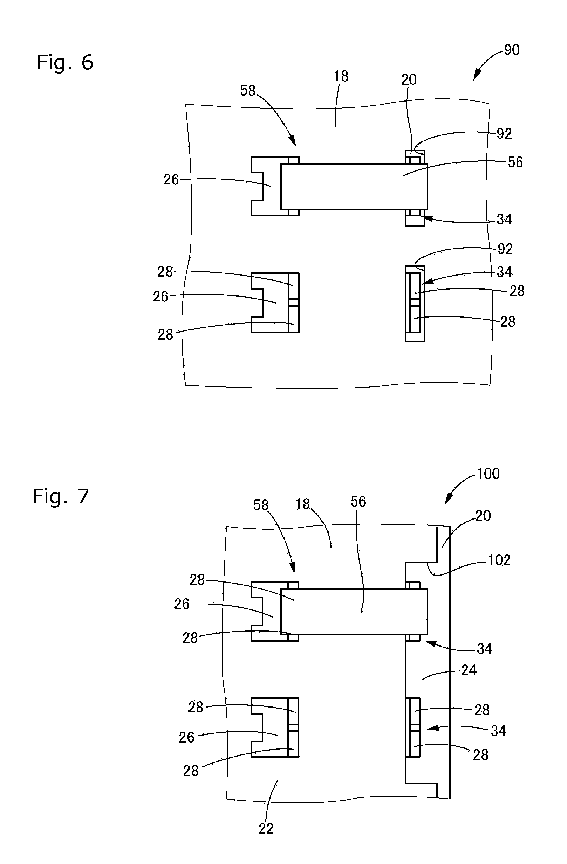

Note that the specific structure of the printed circuit board stack that constitutes the internal circuit of the electrical junction box is not limited to that of the above-described embodiment. For example, Fig. 6 shows a top view of a main portion of a printed circuit board stack 90 that constitutes an internal circuit of an electrical junction box according to a second embodiment of the present invention. In the following description, the same reference numerals as those in the first embodiment are given in the drawings to the members and portions that have the same structures as those in the first embodiment, and descriptions thereof are omitted.

A first printed circuit board 18 and a second printed circuit board 20 according to the present embodiment have substantially the same size when seen in the top view. Through-holes 92 are provided in the central portion of the first printed circuit board 18, and second fork terminals 34 that are provided on the second printed circuit board 20 project upward of the first printed circuit board 18 while passing through the respective through-holes 92, and are arranged so as to face the first fork terminals 26 that are vertically provided on the first printed circuit board 18. In this manner, the first fork terminals 26 and the second fork terminals 34 may also be arranged at positions other than peripheral edge portions of the first printed circuit board 18 and the second printed circuit board 20.

Next, Fig. 7 shows a top view of a main portion of a printed circuit board stack 100 that constitutes an internal circuit of an electrical junction box according to a third embodiment of the present invention. In the present embodiment, a first printed circuit board 18 and a second printed circuit board 20 have substantially the same size, and a peripheral edge portion 22 of the first printed circuit board 18 is arranged above the peripheral edge portion 24 of the second printed circuit board 20 across a gap. A cut-out 102 that is cut inward the first printed circuit board 18 is formed at the peripheral edge portion 22 of the first printed circuit board 18, and second fork terminals 34 that are vertically provided at the peripheral edge portion 24 of the second printed circuit board 20 project upward of the first printed circuit board 18 while passing through the cut-out 102 and are arranged so as to face the first fork terminals 26 that are vertically provided at the peripheral edge portion 22 of the first printed circuit board 18. By providing the cut-out 102 at the peripheral edge portion 22 of the first printed circuit board 18 as in the present embodiment, it is also possible for the second fork terminals 34 to project upward. Note that although, in Fig. 7, a plurality of the second fork terminals 34 are arranged in a common cut-out 102, it is of course possible to form a cut-out 102 for each second fork terminal 34.

Although the embodiments of the present invention have been described in detail, the present invention is not limited by the specific descriptions of the embodiments. For example, the numbers of the front wall-side connector mounting portions to which the power supply input connectors are to be connected and of the rear wall-side connector mounting portions to which the output connectors are to be connected are no way limited, and in the case where there are inputs of, for example, two or more systems, two front wall-side connector mounting portions may also be formed. Alternatively, the number of the rear wall-side connector mounting portions may be set to any suitable value taking into consideration the number of loads to be connected to the electrical junction box, or the like.

Also, the pressure contact blades of the first fork terminals that are vertically provided on the first printed circuit board, and the pressure contact blades of the second fork terminals that are vertically provided on the second printed circuit board do not necessarily need to be arranged at the same level with respect to the direction in which the first printed circuit board and the second printed circuit board face each other. In this case, another configuration is possible in which, for example, the first fork terminals and the second fork terminals that are configured to have the same shape are arranged such that the pressure contact blades of the first fork terminals and the pressure contact blades of the second fork terminals are shifted with respect to each other, and the connection portions of the fuses are made longer.

Further, although the entire peripheral edge portion 22 of the first printed circuit board 18 according to the first embodiment is located inward of the second printed circuit board 20, a configuration is also possible in which, for example, only one side of the peripheral edge portion 22 is located inward of the second printed circuit board 20, and the first fork terminals 26 and the second fork terminals 34 are arranged only on that side.

Furthermore, in the above described embodiments, the numbers of the first fork terminals and the second fork terminals, the shape in which the printed wirings are routed, and the like are, of course, merely examples. The numbers of the first fork terminals and the second fork terminals and locations at which they are arranged, the shape in which the printed wirings are routed, and the like are items that can arbitrarily be set.

### LIST OF REFERENCE NUMERALS

- 10: Electrical junction box
- 15: Case
- 16: Printed circuit board stack (internal circuit)
- 18: First printed circuit board
- 20: Second printed circuit board
- 22: Peripheral edge portion (of first printed circuit board)
- 24: Peripheral edge portion (of second printed circuit board)
- 26: First fork terminal
- 28: Pressure contact blade
- 32, 36: Printed wiring
- 34: Second fork terminal
- 47: Front wall
- 48: Rear wall
- 50: Fuse accommodation cavity
- 53: Front wall-side connector mounting portion
- 55: Rear wall-side connector mounting portion
- 56: Fuse
- 57: Connection portion
- 58: Inter-board connection terminal
- 60: Vehicle interior
- 66: Engine room
- 70: Power supply input connector
- 80 and 82: Output connector

## Claims

1. An electrical junction box (10),
wherein a first printed circuit board (18) and a second printed circuit board (20), which constitute an internal circuit, are accommodated in a case (15),
the internal circuit comprises a printed circuit board stack (16) in which respective printed wirings (32, 36) of the first printed circuit board (18) and the second printed circuit board (20) are electrically connected to each other via an inter-board connection terminal (58), the first printed circuit board (18) and the second printed circuit board (20) being arranged so as to face each other across a gap,
the case (15) has a front wall (47) and a rear wall (48) that are arranged so as to face the printed circuit board stack (16) from both sides in a direction in which the first printed circuit board (18) and the second printed circuit board (20) face each other,
a front wall-side connector mounting portion (53) for mounting a power supply input connector (70) is provided on the front wall (47) of the case (15) in such a manner that the power supply input connector (70) is connectable to the first printed circuit board (18), and
a rear wall-side connector mounting portion (55) for mounting an output connector (80, 82) is provided on the rear wall (48) of the case (15) in such a manner that the output connector (80, 82) is connectable to the second printed circuit board (20).

2. The electrical junction box (10) according to claim 1,
wherein a first fork terminal (26) that is soldered to the printed wiring (32) of the first printed circuit board (18) is vertically arranged on the first printed circuit board (18) whereas a second fork terminal (34) that is soldered to the printed wiring (36) of the second printed circuit board (20) is vertically arranged on the second printed circuit board (20), and
the inter-board connection terminal (58) comprises the first fork terminal (26), the second fork terminal (34), and a fuse (56) that is provided with a pair of connection portions (57), each connection portion (57) being pressure-contacted between pressure contact blades (28) of a respective one of the first fork terminal (26) and the second fork terminal (34).

3. The electrical junction box (10) according to claim 2,
wherein the first fork terminal (26) and the second fork terminal (34) have different heights that are such that the pressure contact blades (28) of the first fork terminal (26) and the pressure contact blades (28) of the second fork terminal (34) are arranged at the same level with respect to a direction in which the fuse (56) is connected.

4. The electrical junction box (10) according to claim 2 or 3,
wherein the second fork terminal (34) is vertically provided at a peripheral edge portion (24) of the second printed circuit board (20), whereas the first fork terminal (26) is vertically provided at a peripheral edge portion (22) of the first printed circuit board (18),
the peripheral edge portion (22) of the first printed circuit board (18) arranged separated from the second printed circuit board (20) across a gap is located inward of the peripheral edge portion (24) of the second printed circuit board (20),
the second fork terminal (34) projects towards and beyond a plane in which the first printed circuit board (18) is arranged, and
the pressure contact blades (28) of the first fork terminal (26) and the pressure contact blades (28) of the second fork terminal (34) are arranged so as to face each other in a direction in which the first and second printed circuit board (18, 20) extend.
